# EUROPEAN PATENT APPLICATION

(11) **EP 1 199 754 A2**
(43) Date of publication of application: **24.04.2002**
(21) Application number: 01106171.0
(22) Date of filing: 13.03.2001
(51) Int. Cl.: H01L 31/18, H01L 31/0224, H01L 31/068

(54) **Photovoltaic cell and process for producing the same**

(30) Priority: 13.10.2000 JP 2000318236
(71) Applicant: Hitachi, Ltd., Chiyoda-ku, Tokyo 101-8010 (JP)
(72) Inventor: Uematsu, Tsuyoshi, Hitachi,Ltd., Int. Prop. Gp., Chiyoda-ku, Tokyo 100-8220 (JP); Yazawa, Yoshiaki, Hitachi, Ltd., Int. Prop. Gp., Chiyoda-ku, Tokyo 100-8220 (JP); Ohtsuka, Hiroyuki, Hitachi, Ltd., Int. Prop. Gp., Chiyoda-ku, Tokyo 100-8220 (JP); Tsutsui, Ken, Hitachi, Ltd., Int. Prop. Group, Chiyoda-ku, Tokyo 100-8220 (JP)
(74) Representative: Strehl Schübel-Hopf & Partner

(57) **Abstract**

A photovoltaic cell produced by adhering a material for masking layer to a surface of a semiconductor substrate in pattern state to form the masking layer, and forming a dopant layer on the portion having no masking layer by gas phase diffusion or solid phase diffusion is high in photoelectric conversion efficiency and is effective for preventing lowering of minority carrier lifetime of the semiconductor substrate.

## Description

### BACKGROUND OF THE INVENTION

This invention relates to a photovoltaic cell and a process for producing the same by using dopant diffusion.

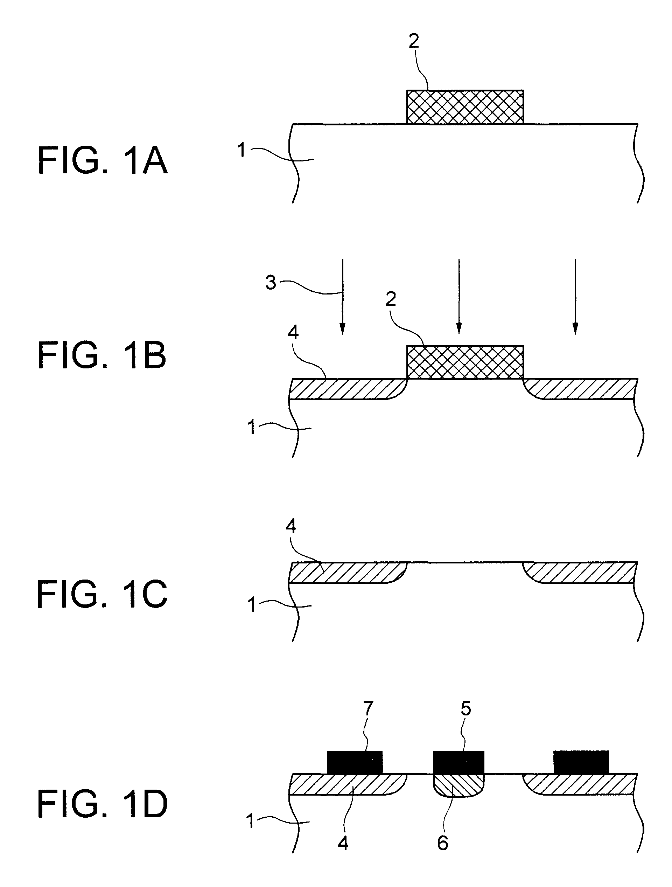

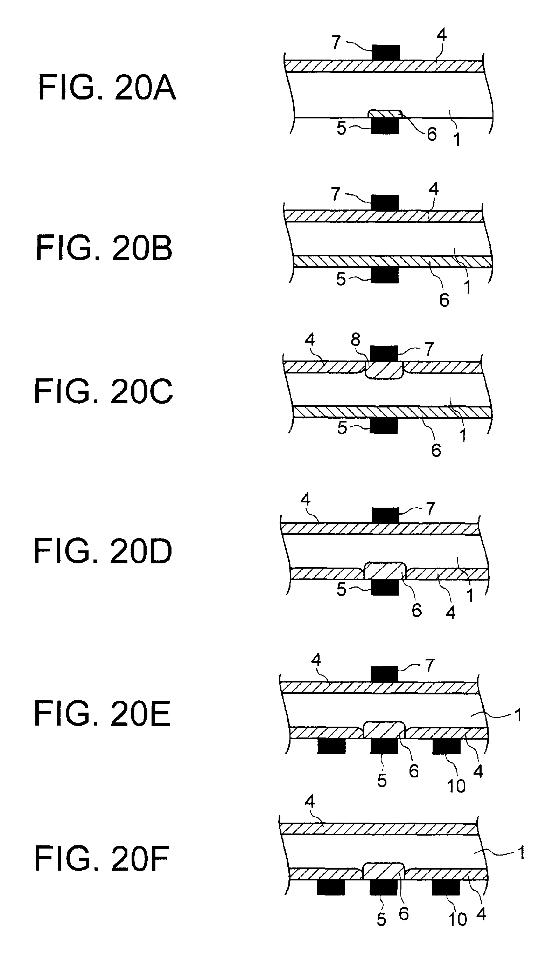

As photovoltaic cells produced by using dopant diffusion, there are known, for example, photovoltaic cells shown by Figs. 20A to 20F. The photovoltaic cell shown in Fig. 20D is disclosed in Fig. 1 (c) of Two Dimensional Study of Alternative Back Surface Passivation Methods for High Efficiency Silicon Solar Cells by M. Ghannam, et al (11th E.C. Photovoltaic Solar Energy Conference, pp 45-48, 1992). In Figs. 20A to 20F, numeral 1 denotes a p-type silicon semiconductor substrate, numerals 4 and 8 denote n-type dopant layers, numeral 6 denotes a p-type dopant layer, and numerals 5, 7, and 10 denote electrodes.

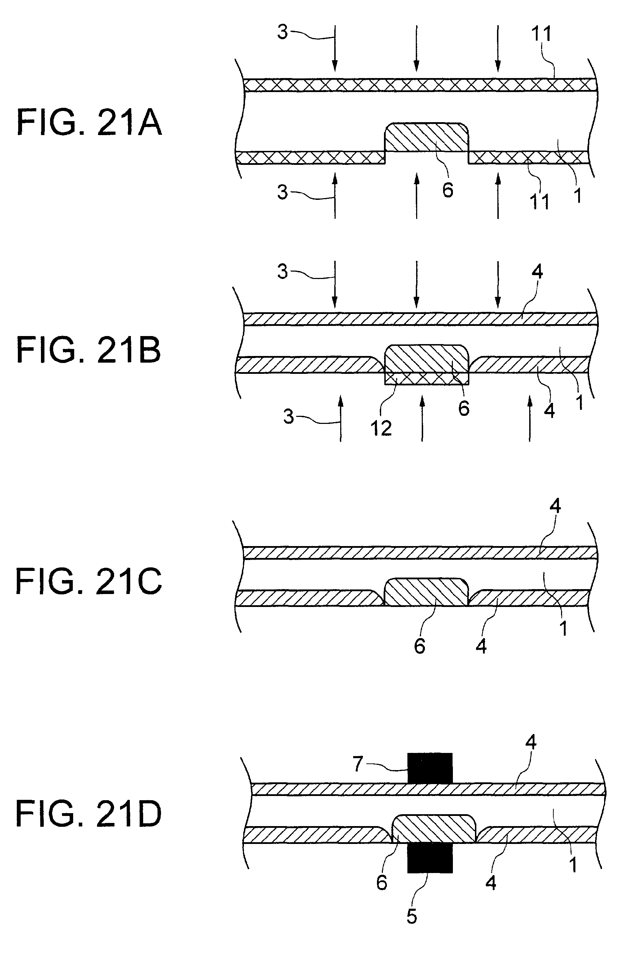

A typical example for producing the known photovoltaic cell of Fig. 20D is explained referring to Figs. 21A to 21D. On surfaces of p-type silicon semiconductor substrate 1, a SiO₂ dopant (or impurity) diffusion preventing films 11 are formed by using thermal oxidation and photolithography and a p-type dopant layer 6 is formed at an opening using a gas 3 containing a dopant which shows p-type in the silicon (Fig. 21A). Then, the SiO₂ dopant diffusion preventing film 11 is removed and a SiO₂ dopant diffusion preventing film 12 is newly formed by using thermal oxidation and photolithography, followed by formation of n-type dopant layers 4 at the openings by gas phase diffusion using a gas 3 containing a dopant which shows n-typ in the silicon (Fig. 21B). Then, the dopant diffusion preventing film 12 is removed (Fig. 21C). Subsequently, silver electrodes 5 and 7 as electrodes for the p-type dopant layer 6 and the n-type dopant layer 4 are formed by a screen printing method (Fig. 21D).

In the above-mentioned production process, since the semiconductor substrate 1 is exposed to high temperatures by thermal oxidation during the formation of two kinds of the SiO₂ dopant diffusion preventing films 11 and 12, a minority carrier lifetime of the semiconductor substrate is lowered. This problem arises not only in the photovoltaic cell of Fig. 20D but also in the rest of photovoltaic cells shown in Figs. 20A to 20F. Further, since the SiO₂ dopant diffusion preventing film 12 is formed on the p-type dopant layer 6, the dopant in the p-type dopant layer 6 redistributes during the formation to change a dopant concentration profile. This problem arises in the photovoltaic cell of not only Fig. 20D but also Figs. 20C, 20 E and 20F, resulting in making the design of photovoltaic cells difficult.

### BRIEF SUMMARY OF THE INVENTION

It is an object of the present invention to provide photovoltaic cells preventing lowering of the minority carrier lifetime of semiconductor substrates and processes for producing the same.

The present invention provides a process for producing a photovoltaic cell, which comprises
a step of forming a dopant diffusion preventing mask on a surface of a semiconductor substrate by adhering a material for the dopant diffusion preventing mask in a pattern state to the semiconductor substrate surface, and
a step of forming a first dopant layer on a portion not covered by the dopant diffusion preventing mask by a first gas phase diffusion.

The present invention also provides a process for producing a photovaltaic cell, which comprises
a step of forming a dopant diffusion preventing mask on a surface of a semiconductor substrate by adhering a material for the dopant diffusion preventing mask in a pattern state to the semiconductor substrate surface,
a step of forming a solid phase diffusion source layer, and
a step of forming a first dopant layer on the portion having no dopant diffusion preventing mask by solid phase diffusion from the solid phase diffusion source layer.

The present invention further provides a photovoltaic cell comprising a semiconductor substrate, an electrically insulating material layer formed on the semiconductor substrate by a coating method, and electrodes formed on openings of the electrically insulating material layer.

The present invention still further provides a photovoltaic cell comprising a semiconductor substrate, and a dopant layer formed on the semiconductor substrate and having different heights by 10 µm or more in periphery shape.

### BRIEF DESCRIPTION OF THE DRAWINGS

Figs. 1A to 1D are diagrammatic views for showing one example of process for producing the photovoltaic cell of the present invention.
Figs. 2A to 2C are diagrammatic views for showing one example of process for producing the photovoltaic cell of the present invention.
Figs. 3A to 3D are diagrammatic views for showing one example of process for producing the photovoltaic cell of the present invention.
Figs. 4A to 4C are diagrammatic views for showing one example of process for producing the photovoltaic cell of the present invention.
Figs. 5A to 5D are diagrammatic views for showing one example of process for producing the photovoltaic cell of the present invention.
Figs. 6A to 6D are diagrammatic views for showing one example of process for producing the photovoltaic cell of the present invention.
Figs. 7A to 7D are diagrammatic views for showing one example of process for producing the photovoltaic cell of the present invention.
Figs. 8A to 8C are diagrammatic views for showing one example of process for producing the photovoltaic cell of the present invention.
Figs. 9A to 9D are diagrammatic views for showing one example of process for producing the photovoltaic cell of the present invention.
Figs. 10A to 10C are diagrammatic views for showing one example of process for producing the photovoltaic cell of the present invention.
Figs. 11A to 11D are diagrammatic views for showing one example of process for producing the photovoltaic cell of the present invention.
Figs. 12A to 12E are diagrammatic views for showing one example of process for producing the photovoltaic cell of the present invention.
Figs. 13A to 13E are diagrammatic views for showing one example of process for producing the photovoltaic cell of the present invention.
Figs. 14A to 14D are diagrammatic views for showing one example of process for producing the photovoltaic cell of the present invention.
Figs. 15A to 15E are diagrammatic views for showing one example of process for producing the photovoltaic cell of the present invention.
Figs. 16A to 16E are diagrammatic views for showing one example of process for producing the photovoltaic cell of the present invention.
Figs. 17A to 17F are diagrammatic views for showing one example of process for producing the photovoltaic cell of the present invention.
Figs. 18A to 18C are diagrammatic views for showing one example of process for producing the photovoltaic cell of the present invention.
Fig. 19 is a diagrammatic view for explaining the structure of the photovoltaic cell of the present invention.
Figs. 20A to 20F are diagrammatic views for explaining the structures of known photovoltaic cells.
Figs. 21A to 21D are diagrammatic views for showing one example of process for producing a known photovoltaic cell.

### DETAILED DESCRIPTION OF THE INVENTION

In order to prevent the lowering of minority carrier lifetime of the semiconductor device, the present inventors found that such an object can be attained by adhering a material for a dopant diffusion preventing mask (hereinafter referred to as "a masking layer") to a surface of semiconductor substrate in pattern state to form the masking layer and forming a dopant layer on the portion wherein no masking layer is present by gas phase diffusion or solid phase diffusion. The adhesion of the material for the masking layer can be carried out by a coating method such as a printing method, e.g. a screen printing method, an ink jet method, etc., a spraying method, a chemical vapor deposition (CVD) method such as plasma CVD, thermal CVD, etc.

The term "gas phase diffusion method" means a diffusion method wherein atoms fly through a space and reach the substrate, and includes an implantation method, a plasma diffusion method, etc.

In the present invention, since the masking layer, which functions as a mask at the time of forming the dopant layer by the gas phase diffusion or solid phase diffusion, is formed by adhering the material for the masking layer in a pattern state to the substrate not using the thermal oxidation method and the photolithographic method, the semiconductor substrate is not exposed to high temperatures. As a result, lowering in the minority carrier lifetime can be prevented.

The present invention includes the following preferable embodiments.
(1) A process for producing a photovoltaic cell, which comprises
   a step of forming a dopant diffusion preventing mask on a surface of a semiconductor substrate by adhering a material for the dopant diffusion preventing mask in a pattern state to the semiconductor substrate surface, and
   a step of forming a first dopant layer on a portion not covered by the dopant diffusion preventing mask by a first gas phase diffusion, followed by conventional steps for completing the photovoltaic cell.
(2) A process mentioned in above (1), which further comprises
   a step of removing the dopant diffusion preventing mask after the first dopant layer forming step, and
   a step of forming a second dopant layer by a second gas phase diffusion on the region from which the dopant diffusion preventing mask is removed.

   The first and second gas phase diffusion can be the same or different conventional gas phase diffusion methods. Further, the first and second dopant layers can be the same or different depending on the kind of dopant used.
(3) A process mentioned in above (1), wherein the dopant diffusion preventing mask contains a dopant so as to function as a solid phase diffusion source, and a third dopant layer is formed under the dopant diffusion preventing mask.
(4) A process mentioned in above (1), wherein the semiconductor substrate is made of silicon, the dopant diffusion preventing mask is made of an electrically insulating material and has an opening, said process further comprises after the step of forming the first dopant layer
   a step of coating a metal containing a dopant which decides a type of electroconductivity in the opening in the dopant diffusion preventing mask,
   a step of converting the first dopant layer to a dopant layer having an opposite electroconductivity by firing, and
   a step of forming a metallic electrode for the impurity layer having the opposite electroconductivity.
(5) A process mentioned in above (1), wherein the semiconductor substrate is made of silicon, the dopant diffusion preventing mask is made of an electrically insulating material and has an opening, said process further comprises after the step of forming the first dopant layer
   a step of coating aluminum containing a dopant which decides a type of electroconductivity in the opening in the dopant diffusion preventing mask,
   a step of converting the first dopant layer to a p-type dopant layer by firing, and
   a step of forming an aluminum electrode for the p-type dopant layer.
(6) A process mentioned in above (1), wherein a dopant layer having an opposite electroconductivity to the first dopant layer is formed before the step of formation of the dopant diffusion preventing mask.
(7) A process mentioned in above (1), wherein the semiconductor substrate has a through-hole which penetrates from a front surface to a rear surface and said process comprising
   a step of forming the first dopant layer on the front surface and rear surface of the semiconductor substrate having no dopant diffusion preventing mask and inside wall of the through-hole by the first gas phase diffusion.
(8) A process for producing a photovaltaic cell, which comprises
   a step of forming a dopant diffusion preventing mask on a surface of a semiconductor substrate by adhering a material for the dopant diffusion preventing mask in a pattern state to the semiconductor substrate surface,
   a step of forming a solid phase diffusion source layer, and
   a step of forming a first dopant layer on the portion having no dopant diffusion preventing mask by solid phase diffusion from the solid phase diffusion source layer, followed by conventional steps for completing the photovoltaic cell.
(9) A process mentioned in above (8), wherein the dopant diffusion preventing mask contains a dopant so as to function as a solid phase diffusion source, and a second dopant layer is formed under the dopant diffusion preventing mask.
(10) A process mentioned in above (1) or (8), wherein the material for the dopant diffusion preventing mask is adhered to the semiconductor substrate by a printing method.
(11) A process mentioned in above (1) or (8), wherein the material for the dopant diffusion preventing mask contains silicon oxide or silicon nitride.
(12) A process mentioned in above (1), wherein the material for the dopant diffusion preventing mask has a viscosity of 500,000 cp to 1,000,000 cp.
(13) A process mentioned in above (8), wherein the material for the dopant diffusion preventing mask and a material for the solid phase diffusion source layer have a viscosity of 500,000 cp to 1,000,000 cp.
(14) A photovoltaic cell comprising a semiconductor substrate, an electrically insulating material layer formed on the semiconductor substrate by a coating method, and electrodes formed on openings of the electrically insulating material layer.
(15) A photovoltaic cell mentioned in above (14), which further comprises a first dopant layer formed on outside of the electrically insulating material layer on the semiconductor substrate, and a second dopant layer having an opposite electroconductivity to the first dopant layer and formed in the opening of the electrically insulating material layer, said second dopant layer containing p-type dopant and n-type dopant.
(16) A photovoltaic cell mentioned in above (15), wherein the fist dopant layer is an n-type dopant layer, the second dopant layer is a p-type dopant layer, the semiconductor substate is made of silicon, the electrode is made of aluminum, and said p-type dopant layer contains aluminum and an n-type dopant.
(17) A photovoltaic cell comprising a semiconductor substrate, and a dopant layer formed on the semiconductor substrate and having different heights by 10 µm or more in periphery shape.
(18) A photovoltaic cell mentioned in above (17), which further comprises a through-hole penetrating the semiconductor substrate from a front surface to a rear surface, and a dopant layer having the same electroconductivity and connecting the front surface, the rear surface and inside of through-hole.

The present invention is illustrated by way of the following Examples, but needless to say, the present invention is not limited to these Examples.

### Example 1

The photovoltaic cell of the present invention is produced by the process shown in Figs. 1A to 1D.

First, a highly viscous material containing silicon oxide is coated on a surface of p-type silicon semiconductor substrate 1 by a screen printing method in a pattern state, followed by firing to form a silicon oxide masking layer 2 (Fig. 1A).

Then, an n-type dopant layer 4 is formed on the portions having no masking layer 2 by gas phase diffusion using a gas 3 containing phosphorus which is a dopant showing n-type in silicon (Fig. 1B). The diffusion temperature is 870°C.

Then, the masking layer 2 is removed by using a hydrofluoric acid solution (Fig. 1C).

Subsequently, an aluminum electrode 5 and a p-type dopant layer 6 are formed by coating aluminum in a pattern state using a screen printing method, followed by firing. As an electrode for an n-type dopant layer 4, a silver electrode 7 is formed by a screen printing method (Fig. 1D).

In this Example, the pn junction of the photovoltaic cell is constituted by the n-type dopant layer 4 and the p-type silicon semiconductor substrate 1. Further, even if the electroconductivity of the silicon semiconductor substrate 1 is n-type, the resulting product functions as a photovoltaic cell. In this case, the pn junction is constituted by the p-type dopant layer 6 and the n-type silicon semiconductor substrate.

As mentioned above, even if the electroconductivity of semiconductor substrate is changed, there can be obtained a structure which can function as a photovoltaic cell. Such a structure will be disclosed in the following Examples sometimes, but the explanation is provided only to the use of p-type silicon semiconductor substrate 1 for simplicity.

In this Example, the masking layer 2 is formed by the screen printing method, but not limited thereto. There can be used other printing method such as an ink jet method, or the like. Further, by using a metal mask, the silicon oxide film can be deposited thereupon by plasma CVD, thermal CVD, or the like. In addition, the masking layer can be formed by using a silicon nitride (SiNₓ) film, or the like.

According to this Example, since the masking layer 2 for the n-type dopant layer 4 and the silver electrode 7 are formed by the same method (the screen printing method), the tendency of deviation of pattern in the plane of semiconductor substrate 1 is the same. As a result, the generation percent of badness caused by misregistration can be reduced. This effect can also be seen in the following Examples taking the same constructing portion as this Example.

### Example 2

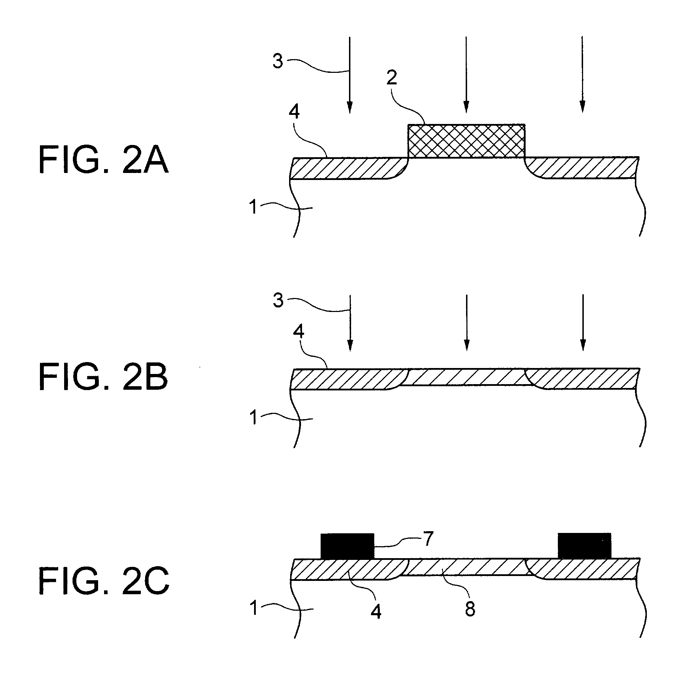

A photovoltaic cell of this Example is produced by the process shown in Figs. 2A to 2C. In this Example, a dopant layer 4 and a dopant layer 8 having the same electroconductivity and different dopant concentration profiles in the depth direction are formed on one surface of a semiconductor substrate 1.

First, an n-type dopant layer 4 is formed in the same manner as described in Example 1 (Fig. 2A). Then, a masking layer 2 is removed by using a hydrofluoric acid solution, followed by diffusion of an n-type dopant at 830°C by gas phase diffusion using a gas 3 containing phosphorus which is a dopant showing n-type in silicon (Fig. 2B).

As a result, thre is formed on a portion from which the masking layer 2 is removed an n-type dopant layer 8, which has a different dopant concentration profile in the depth direction compared with the n-type dopant layer 4 and shallower in diffusion depth than the n-type dopant layer 4. This is because the diffusion temperature (830°C) at the time of the formation of the n-type dopant layer 8 is lower than the diffusion temperature (870°C) at the time of formation of the n-type dopant layer 4. The influence of this gas phase diffution on the n-type dopant layer 4 previously formed is small. As mentioned above, by making the diffusion depth of the n-type dopant layer 8 which becomes a light receiving place shallow, the photoelectric conversion efficiency can be enhanced.

Thereafter, a silver electrode 7 for the n-type dopant layer 4 is formed by a screen printing method (Fig. 2C). In the same manner, as an electrode for the p-type semiconductor substrate 1, a silver electrode is formed by a screen printing method on a rear side of the p-type semiconductor substrate 1 (not shown in the drawing).

### Example 3

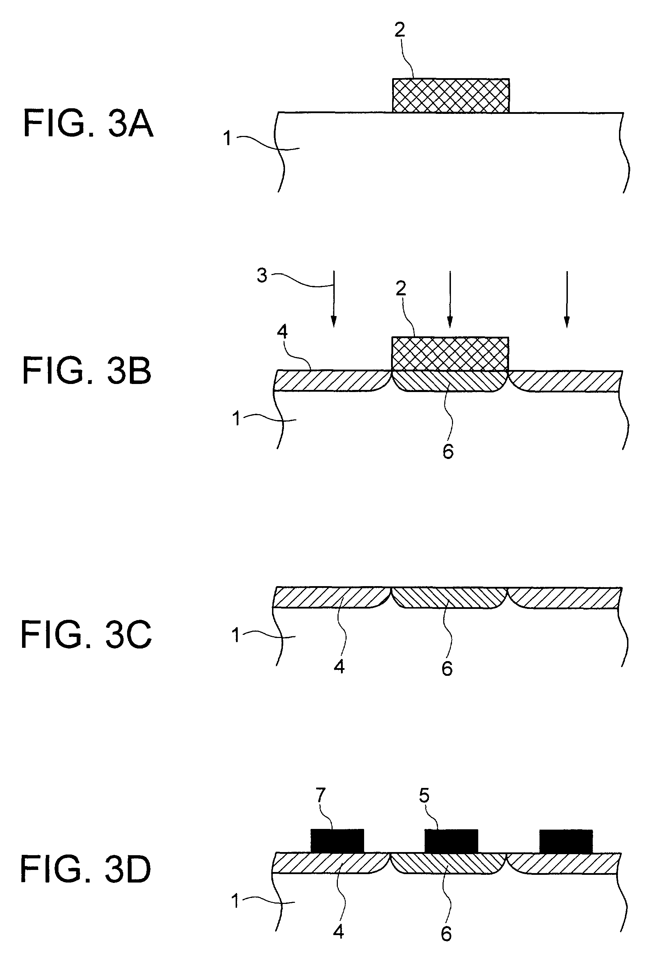

A photovoltaic cell of this Example is produced by the process shown in Figs. 3A to 3D. In this Example, the masking layer 2 is also used as a solid phase diffusion source.

First, on a surface of p-type silicon semiconductor substrate 1, a highly viscous material containing silicon oxide including boron which is a dopant showing p-type in silicon is coated by a screen printing method in pattern state, followed by firing to form a silicon oxide masking layer 2 (Fig. 3A).

Then, using a gas 3 containing phosphorus which is a dopant showing n-type in silicon, an n-type dopant layer 4 is formed by gas phase diffusion on the portion wherein no masking layer 2 is present. The diffusion temperature is 950°C. At this time, the masking layer 2 functions as a solid phase diffusion source and forms a p-type dopant layer 6 under the masking layer 2 at the same time (Fig. 3B).

Then, the masking layer 2 is removed by using a hydrofluoric acid solution (Fig. 3C).

Subsequently, electrodes 5 and 7 made of silver are formed by using a screen printing method (Fig. 3D).

In the Example of Figs. 3A to 3D, the type of electroconductivity of dopant layers is different depending on the portions having the masking layer 2 or not (the p-type dopant layer 6 and the n-type dopant layer 4). But it is possible to make the type of electroconductivity the same, or to make the dopant concentration profile in the depth direction in the same electroconductivity different by properly selecting the type of electroconductivity and concentration of dopant contained in the masking layer 2 as a solid phase diffusion source, the type of electroconductivity and concentration of dopant in gas phase diffusion, treating temperature, treating atmosphere, and the like.

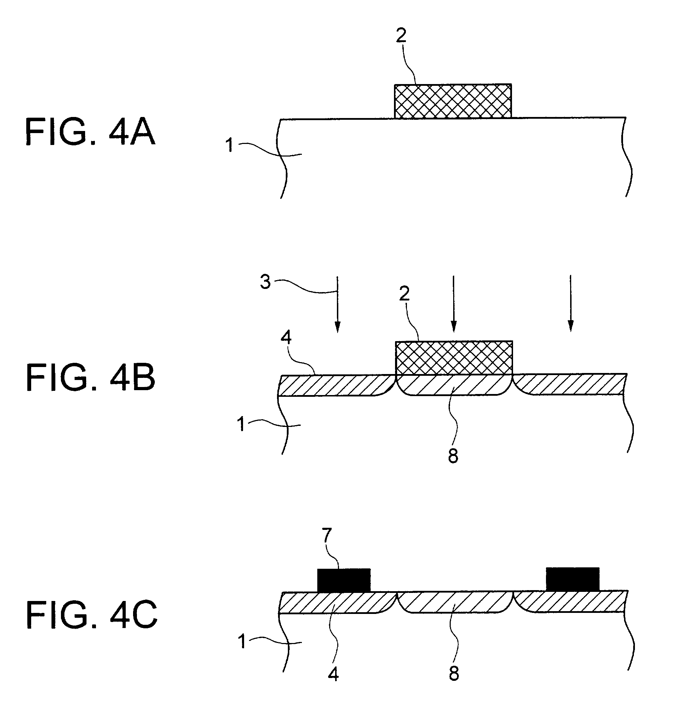

Figs. 4A to 4C shows an example of producing a photovoltaic cell wherein the type of electroconductivity of a dopant layer formed by the gas phase diffusion and that of a dopant layer fomred by using the masking layer 2 as the solid phase diffusion source are made the same. As shown in Fig. 4B, an n-type dopant layer 4 is formed by gas phase diffusion and an n-type dopant layer 8 is formed by using the solid phase diffusion source at the same time. An electrode (not shown in the drawing) for p-type semiconductor substrate 1 is formed by using silver on a rear side of the p-type semiconductor substrate 1 by a screen printing method.

### Example 4

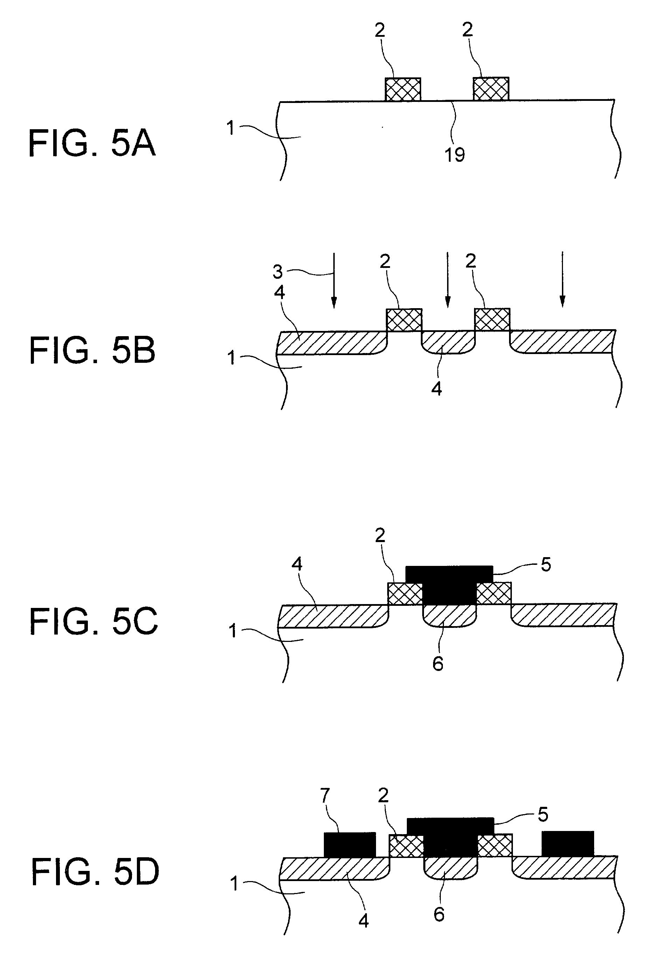

A photovoltaic cell of this Example is produced by the process shown in Figs. 5A to 5D. This Example is fundamentally the same as Example 1. This Example is characterized by retaining the masking layer 2 finally, and opening the inside of masking layer to make a contact portion 19 of an electrode 5 and the semiconductor. When the masking layer 2 is finally retained in the photovoltaic cell as in this Example, it is necessary to make the masking layer 2 from an electrically insulating substance.

First, on a surface of p-type silicon semiconductor substrate 1, a highly viscous material containing silicon oxide is coated by a screen printing method so as to have an opening at the contact portion 19, followed by firing to form the masking layer 2 made of silicon oxide (Fig. 5A).

Then, using a gas 3 containing phosphorus as a dopant showing n-type in silicon, an n-type dopant layer 4 is formed by gas phase diffusion on the portion wherein the masking layer 2 is not present (Fig. 5B). The diffusion temperature is 870°C.

Subsequently, aluminum is coated in pattern shape by a screen printing method, while retaining the masking layer 2, followed by firing to form an aluminum electrode 5. At this time, at the contact portion 19, a p-type alloy layer is formed from aluminum and the semiconductor. This alloy layer penetrates the n-type dopant layer 4 to form a p-type dopant layer 6 by converting the n-type dopant layer 4 to the p-type (Fig. 5C). As an electrode for another n-type dopant layer 4, a silver electrode 7 is formed by a screen printing method (Fig. 5D).

In this Example, aluminum is used as a material for electrode 5, but when a material for electrode 5 containing antimony is used, it is possible to form an n-type alloy layer. When a metal which hardly forms an alloy layer with semiconductor is used as a material for the electrode 5, it is possible to form contact of the n-type dopant layer 4 and the electrode 5 as shown in Fig. 5B. But even in this case, it is possible to obtain direct contact with the p-type silicon semiconductor substrate 1 by penetrating the n-type dopant layer 4 when subjected to proper heat treatment, or the like.

### Example 5

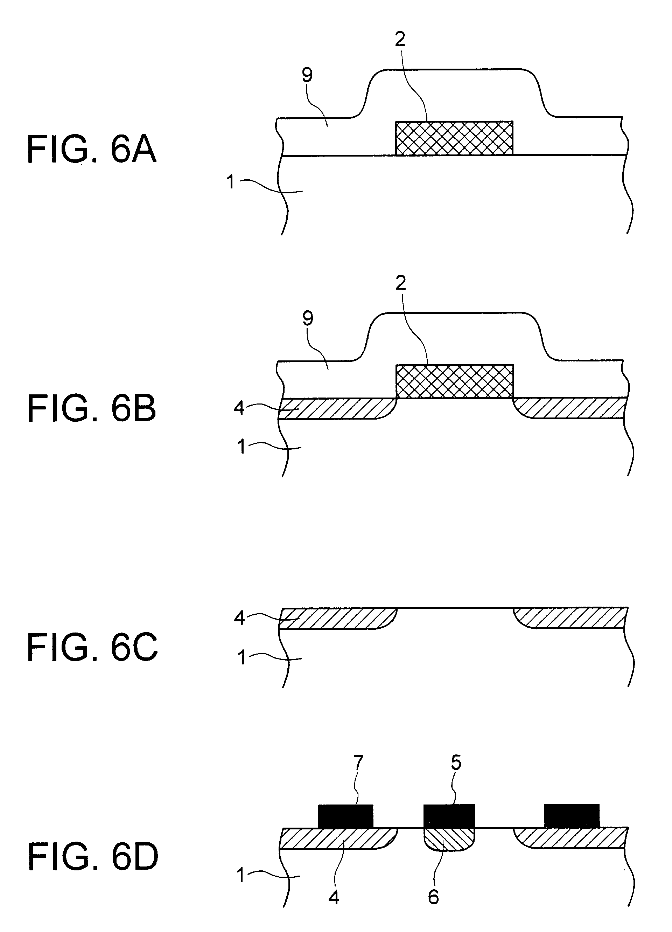

A photovoltaic cell of this Example is produced by the process shown in Figs. 6A to 6D. In this Example, solid phase diffusion is used in place of the gas phase diffusion used in Example 1.

As shown in Fig. 6A, after forming a silicon oxide masking layer 2, a silicon oxide solid phase diffusion source film 9 functioning as a solid phase diffusion source is formed on the whole surface of a p-type silicon semiconductor substrate 1 using a screen printing method. The solid phase diffusion source film 9 contains phosphorus therein which is a dopant showing n-type in silicon.

After heat treating at 870°C, an n-type dopant layer 4 is formed on the portion wherein the masking layer 2 is not present (Fig. 6B).

Then, the solid phase diffusion source film 9 and the masking layer 2 are removed by using a hydrofluoric acid solution (Fig. 6C). Subsequently, aluminum is coated in pattern state using a screen printing method, followed by firing to form an aluminum electrode 5 and a p-type dopant layer 6 under the electrode 5. Further, as an electrode for the n-type dopant layer 4, a silver electrode 7 is formed by using a screen printing method (Fig. 6D).

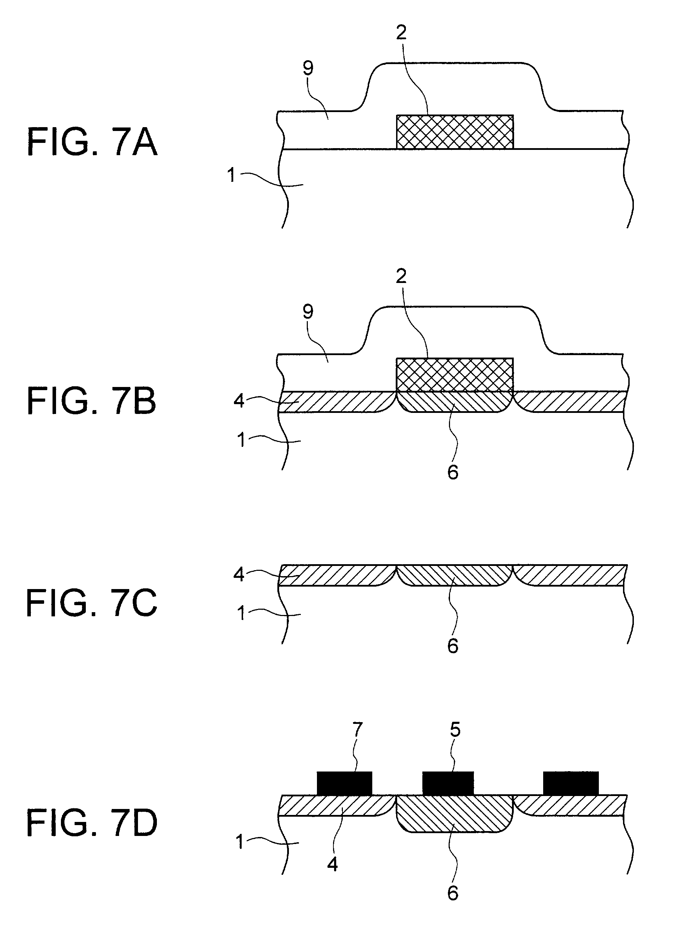

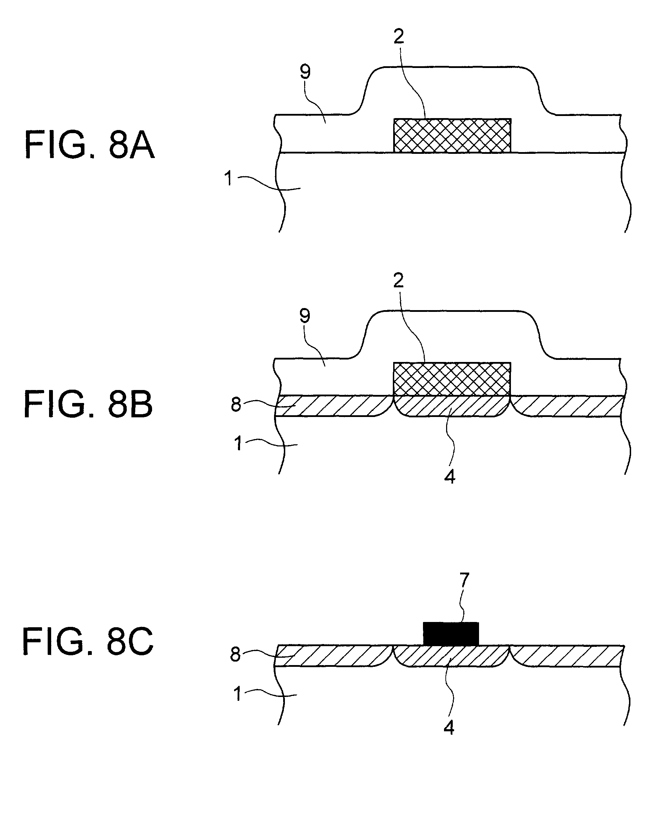

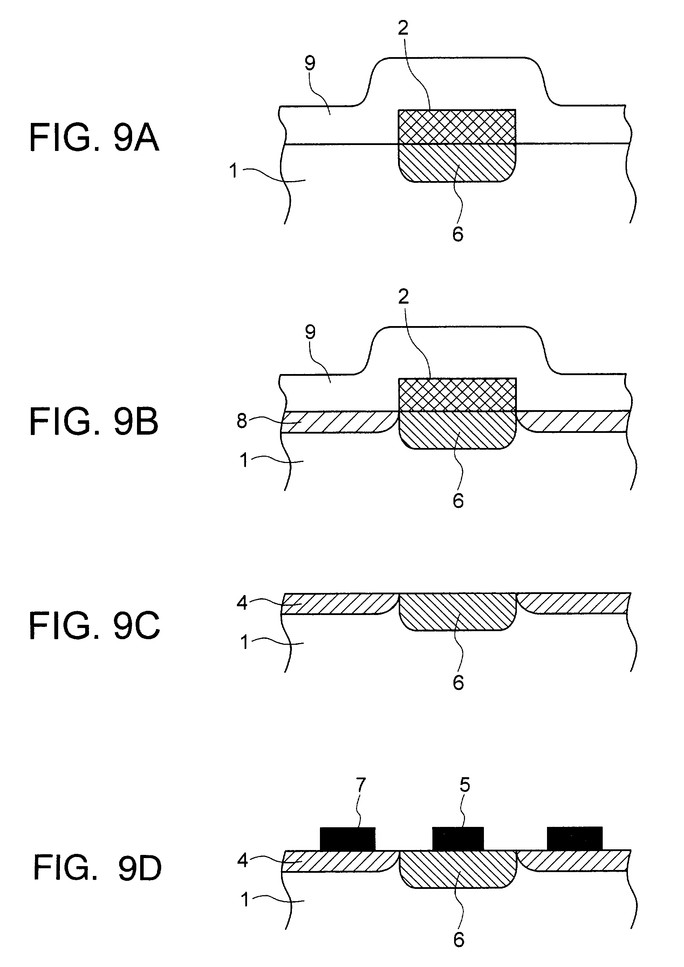

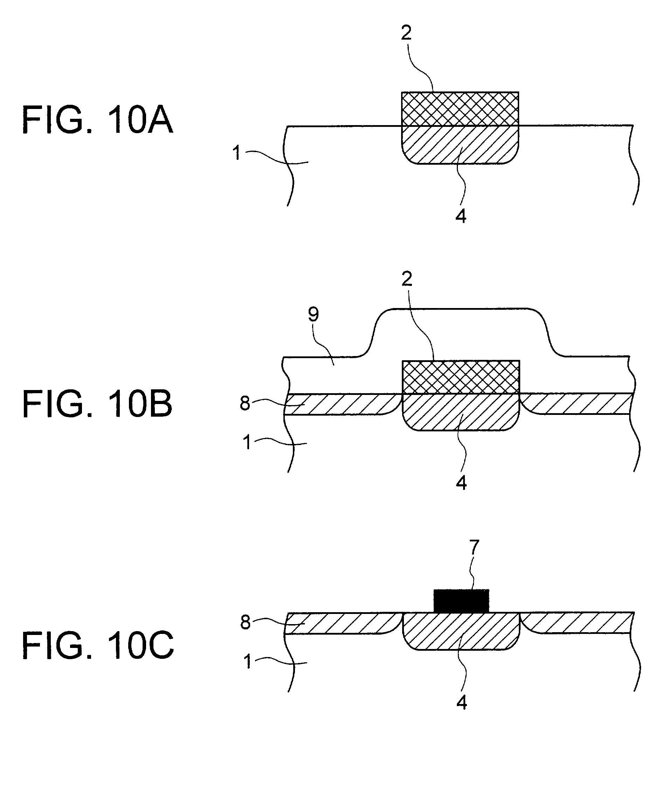

Based on the process of this Example, photovoltaic cells having structures shown in Figs. 7D, 8C, 9D, and 10C can be produced by changing the type of electroconductivity of dopant contained in the solid phase diffusion source film 9, the concentration of dopant, the heat treatment temperature, the heat treatment time, the timing of the formation of solid phase diffusion source film 9 by the processes shown in Figs. 7A to 7D, 8A to 8C, 9A to 9D and 10A to 10C.

### Example 6

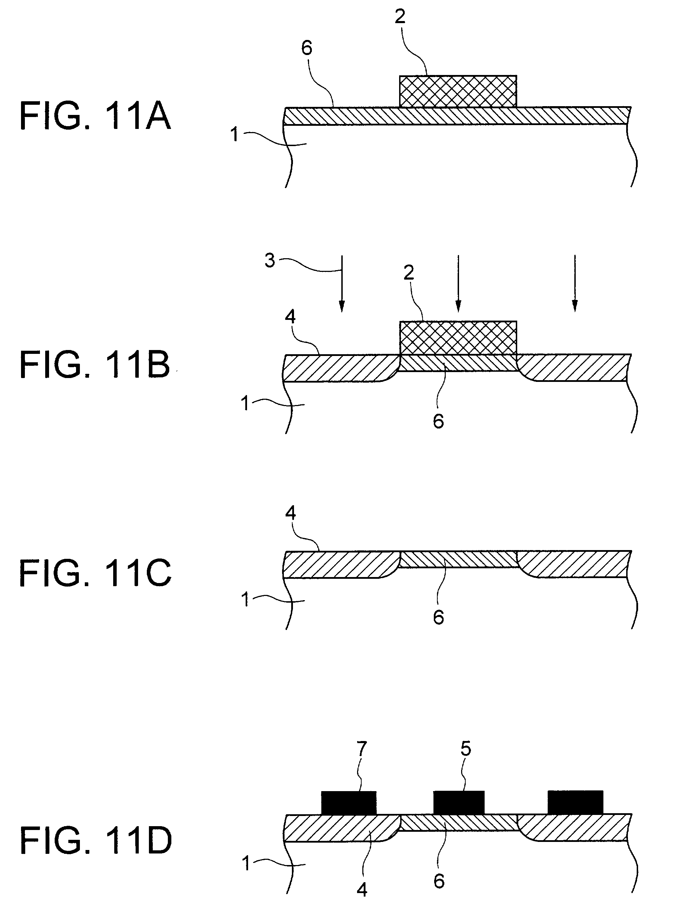

A photovoltaic cell of this Example is produced by the process shown in Figs. 11A to 11D.

In this Example, after forming a p-type dopant layer 6 by gas phase diffusion on the whole surface of a p-type silicon semiconductor substrate 1, a masking layer 2 is formed (Fig. 11A). Then, on the portion having no masking layer 2 of the surface of the p-type silicon substrate 1, an n-type dopant layer 4 is formed by converting the p-type dopant layer 6 by gas phase growth (Fig. 11B). In Figs. 11A to 11D, other conditions for production steps are the same as those of Example 1.

In the above process, an n-type dopant layer 4 can previously be formed on the whole surface of a p-type silicon semiconductor substrate 1, followed by conversion of the n-type dopant layer 4 under the masking layer 2 to a p-type dopant layer 6 by using the masking layer 2 also as a solid phase diffusion source.

### Example 7

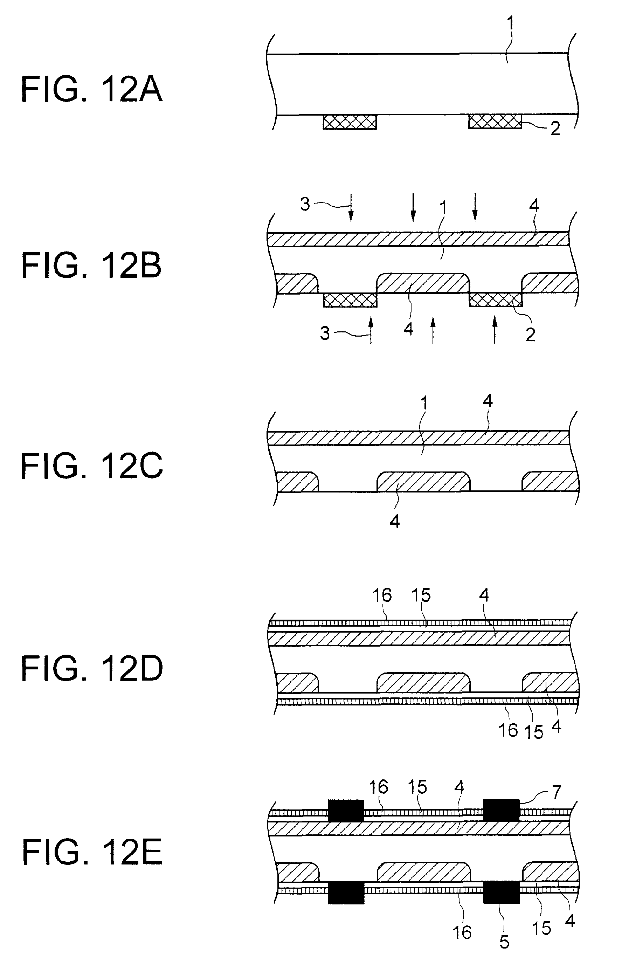

A photovoltaic cell of this Example is produced by the process shown in Figs. 12A to 12E.

First, on a rear side of a p-type silicon semiconductor substrate 1 having resistivity of 3 Ω•cm, a masking layer 2 having about 1 µm thickness is formed (Fig. 12A).

Then, a nitrogen gas containing POCl₃ is blown on both surfaces of the p-type semiconductor substrate 1 at 870°C as a dopant diffusion gas 3 having n-type electroconductivity to form an n-type dopant layer 4 on the portions having no masking layer 2 (Fig. 12B). The n-type dopant layer 4 on the rear side functions as an n float.

Then, the masking layer 2 is removed (Fig. 12C). Subsequently, thermal oxidation is conducted at 800°C to form an oxidation passivation film 15, on which a silicon nitride antireflection coating film 16 is formed by plasma CVD method (Fig. 12D).

Next, a silver electrode 7 for the n-type dopant layer 4 on the front surface and an aluminum electrode 5 for the p-type semiconductor substrate 1 are formed by using a screen printing method, while penetrating the antireflection coating film 16 and passivation film 15, respectively (Fig. 12E). In Figs. 12A to 12E, other conditions for production steps are the same as those in Example 1.

### Example 8

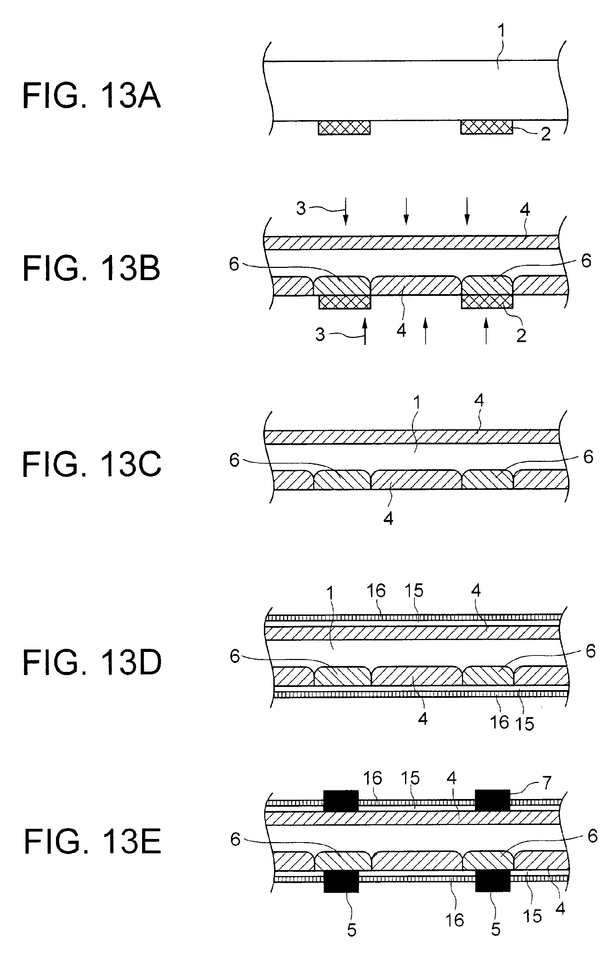

A float-type photovoltaic cell of this Example is produced by the process shown in Figs. 13A to 13E. In this Example, the steps are the same as those in Example 7 except for using the masking layer 2 as a solid phase diffusion source. At the time of forming an n-type dopant layer 4 by gas phase diffusion, a p-type dopant layer 6 is formed by solid phase diffusion. Conditions for producing the solid phase diffusion source are the same as those in Example 3. Other production conditions are the same as those in Example 1.

Since good p-type dopant layer 6 can be formed on a surface of the semiconductor substrate 1 under the electrode 5 at the rear side (Fig. 13E), the photovoltaic cell having high photoelectric conversion efficiency can be produced simply.

### Example 9

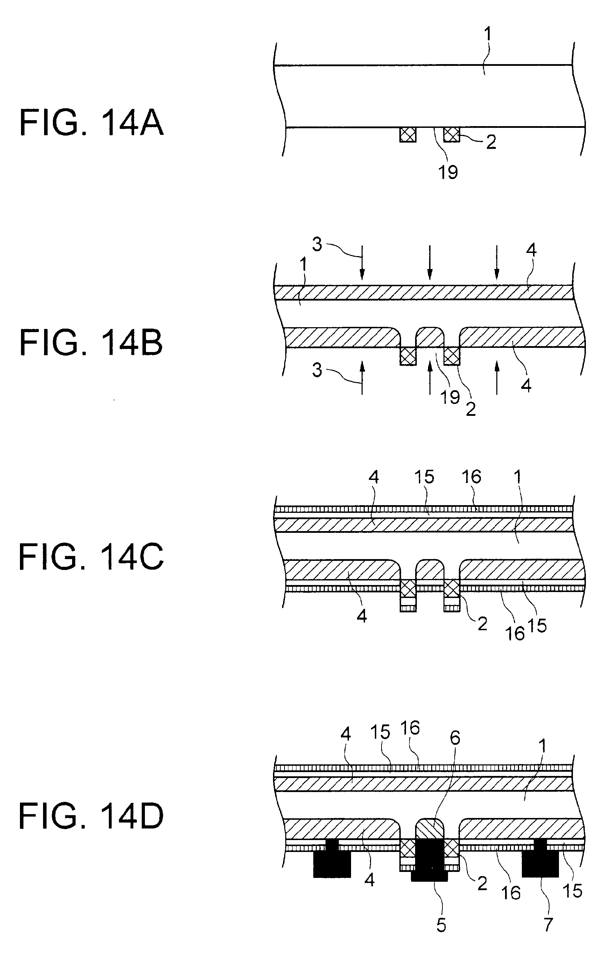

A float-type photovolatic cell of this Example is produced by the process shown in Figs. 14A to 14D. This Example is characterized by retaining the masking layer 2 finally and opening the inside of the layer 2 to make a contact portion 19 of the electrode 5 and the semiconductor.

First, on a rear side of a p-type silicon semiconductor substrate 1 having resistivity of 3 Ω•cm, a masking layer 2 having about 1 µm thickness and an opening at a contact portion 19 is formed (Fig. 14A).

Then, a nitrogen gas containing POCl₃ is blown on both surfaces of the p-type semiconductor substrate 1 at 870°C as a dopant diffusion gas 3 having n-type electroconductivity to form an n-type dopant layer 4 on the portions having no masking layer 2 (Fig. 14B). The n-type dopant layer 4 on the rear side functions as an n float.

Then, while retaining the masking layer 2, thermal oxidation is conducted at 800°C to form an oxidation passivation film 15, on which a silicon nitride antireflection coating film 16 is formed by plasma CVD method (Fig. 14C).

Next, a silver electrode 7 for the n-type dopant layer 4 on the rear surface and an aluminum electrode 5 for the p-type semiconductor substrate 1 are formed by using a screen printing method, while penetrating the antireflection coating film 16 and passivation film 15, respectively. At this time, by firing the aluminum electrode 5 at 750°C, a p-type dopant layer 6 is formed under the electrode 5 (Fig. 14D). In Figs. 14A to 14D, other conditions for production steps are the same as those in Example 4.

### Example 10

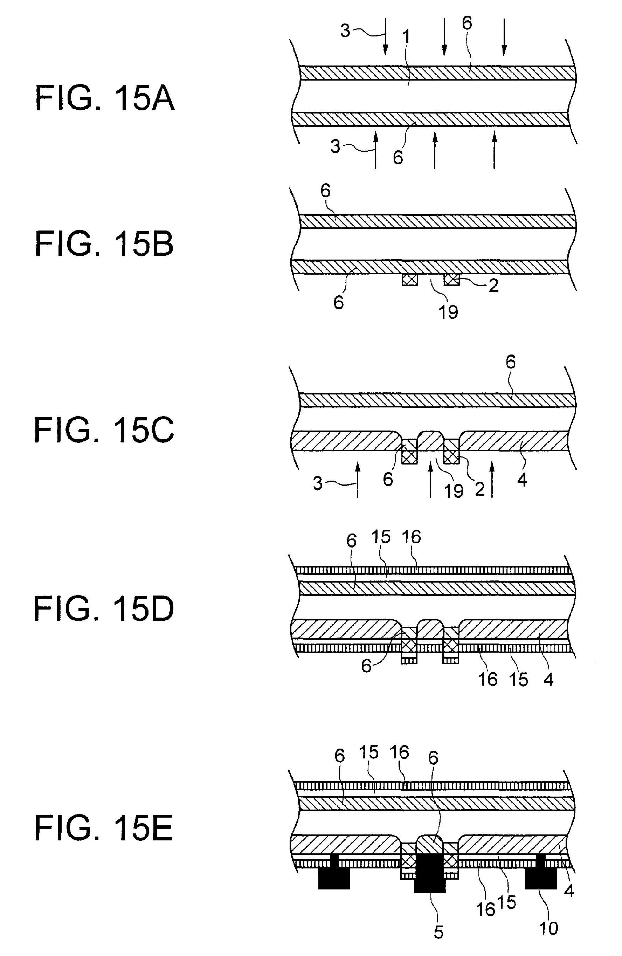

A high-low junction type photovoltaic cell is produced by the process shown in Figs. 15A to 15E. This Example is characterized by retaining the masking layer 2 finally and opening the inside of the layer 2 to make a contact portion 19 of the electrode 5 and the semiconductor.

First, a nitrogen gas containing BBr₃ as a p-type dopant diffusion gas 3 is blown on both surfaces of a p-type silicon semiconductor substrate 1 having resistivity of 3 Ω•cm at 950°C to form a p-type dopant layer 6 (Fig. 15A).

Then, on rear side of the p-type silicon semiconductor substrate 1, a masking layer 2 having about 1 µm thickness and an opening at a contact portion 19 is formed (Fig. 15B).

Next, the portion of the rear side of the p-type silicon semiconductor substrate 1 having no masking layer 2 is subjected to conversion of the type of electroconductivity by gas phase diffusion only on the rear side by a back to back diffusion method to form an n-type dopant layer 4 (Fig. 15C).

Then, while retaining the masking layer 2, thermal oxidation is conducted at 800°C to form an oxidation passivation film 15, on which a titanium oxide (TiO₂) antireflection coating film 16 is formed by thermal CVD method (Fig. 15D).

Next, a silver electrode 10 for the n-type dopant layer 4 on the rear surface and an aluminum electrode 5 for the p-type dopant layer 6 are formed by using a screen printing method, while penetrating the antireflection coating film 16 and passivation film 15, respectively. At this time, by firing the aluminum electrode 5 at 750°C, the dopant concentration of the p-type dopant layer 6 under the electrode 5 is increased (Fig. 15E). In Figs. 15A to 15E, other conditions for production steps are the same as those in Example 4.

### Example 11

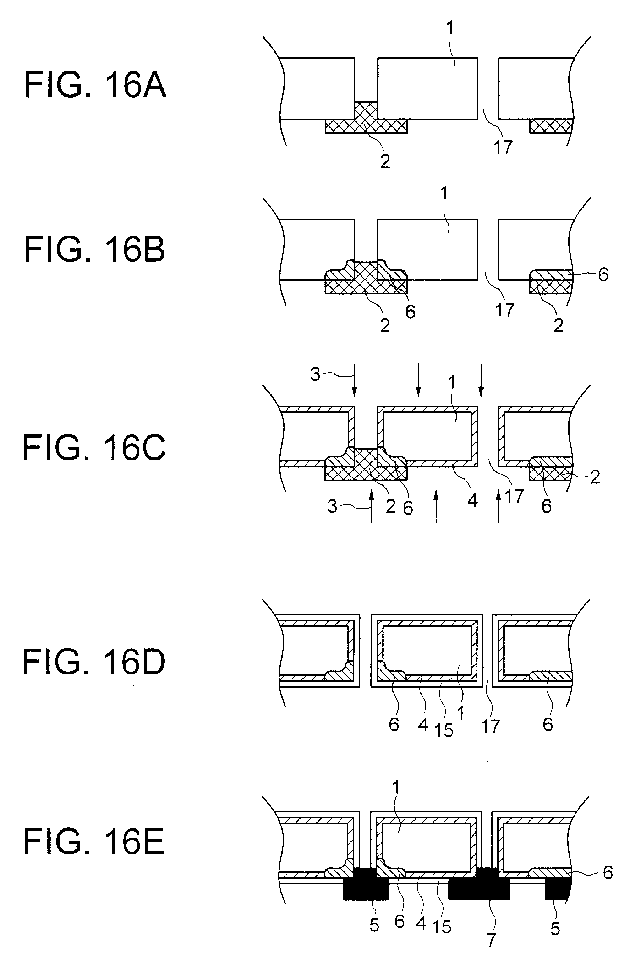

A photovoltaic cell of this Example is produced by the process shown in Figs. 16A to 16E. In this Example, a through-hole 17 is made in, for example, a p-type silicon semiconductor substrate 1. In such a photovoltaic cell, since an n layer on the front surface and an n layer on the rear surface are connected by forming an n-type dopant layer 4 on the front surface, rear surface and inside of the through-hole 17, the minority carrier generated on the front surface can be collected to the electrode 7 efficiently, resulting in producing the photovoltaic cell having high photoelectric conversion efficiency.

First, a masking layer 2 containing boron is formed so as to partly cover the rear side of the through-hole of the p-type silicon semiconductor substrate 1 (Fig. 16A). Then, the boron in the masking layer 2 is diffused in the p-type silicon semiconductor substrate 1 by heat treatment at 900°C to form a p-type dopant layer 6 (Fig. 16B). Next, n-type dopant layers 4 are formed by gas phase diffusion on the portions other than the p-type dopant layer 6 of the p-type silicon semiconductor substrate 1 (Fig. 16C). After removing the masking layer 2, an oxide film 15 is formed by thermal oxidation (Fig. 16D). Finally, a silver electrode 7 for the n-type dopant layer 4 and a silver electrode 5 for the p-type semiconductor substrate 1 are formed through the oxide film 15 by a screen printing method (Fig. 16E). Other production conditions in Figs. 16A to 16E are the same as those in Example 3.

### Example 12

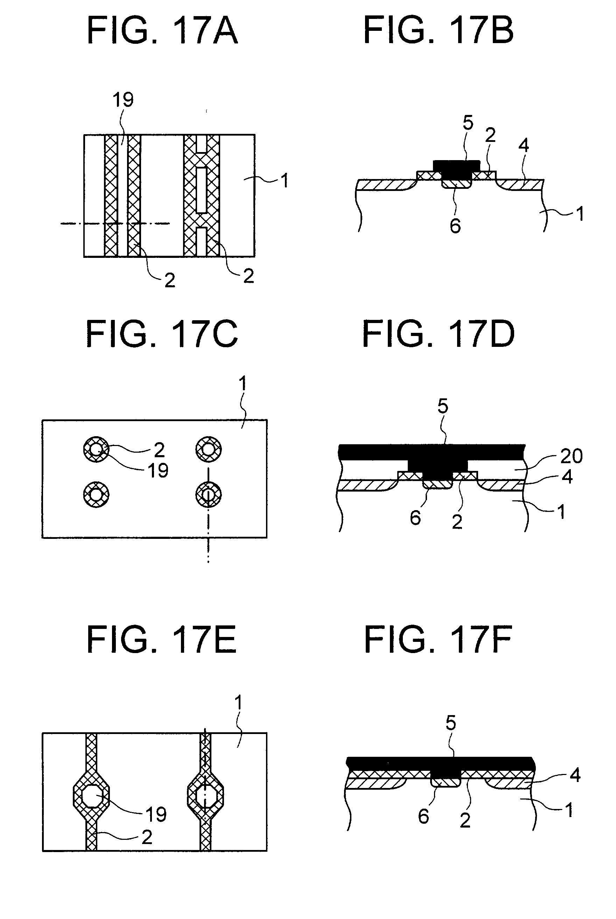

Figs. 17A to 17F show concrete examples of the shape of masking layers 2 having openings used in the process for producing the photovoltaic cells of the present invention. Needless to say, the masking layers 2 of this Example can be used in Examples 4, 9 and 10. In the drawings, Figs. 17A, 17C, and 17E are plan views and Figs. 17B, 17D and 17F are cross-sectional views as taken on a dot and dash line of these plan views.

The masking layer 2 shown at the left-hand side in Fig. 17A has an opening linearly. As shown in Fig. 17B, by making the width of the electrode 5 narrower than that of the masking layer 2, even if the electrode 5 is shifted to right or left to some extent, it does not contact with the n-type dopant layer 4 formed outside of the masking layer 2. Thus, the width of precision is broadened to increase the yield of the production of the photovoltaic cells.

The masking layer 2 shown at the right-hand side in Fig. 17A has an opening so as to have hole-like contact portion 19. By making the area of contact portion 19 between the electrode 5 and the p-type semiconductor substrate small, recombination of minority carrier at the interface between the electrode 5 and the semiconductor substrate 1 can be made small, resulting in improving the photoelectric conversion efficiency.

The masking layer 2 shown in Fig. 17C has an opening in a doughnut shape. Since this shape can reduce the area of the contact portion 19 compared with the shapes of Fig. 17A, the photoelectric conversion efficiency can further be improved. Further, since the area of the n-type dopant layer 4 is also increased, the photoelectric conversion efficiency is also increase by this. As shown in Fig. 17D, it is necessary to connect each contact portion 19 by the electrode 15 in this shape, insulating layers 20 are inserted between the n-type dopant layer 4 and the electrode 5 to insulate both among individual contact portions 19. In the case of a one-side light-receiving type wherein the incident light enters from the substrate side, when a white insulating material is used as the insulating layer 20, the reflection rate of the incident light at the insulating layer 20 increases and a light confinement ratio also increases.

The masking layer 2 shown in Fig. 17E has a shape of a doughnut bonded by lines. In this shape, since the area of contact portion 19 can be reduced compared with the shape of Fig. 17A, the photoelectric conversion efficiency is further improved. In addition, since the area of the n-type dopant layer 4 increases, the photoelectric conversion efficiency is further increased by this. Moreover, comparing with the shape of Fig. 17C, since the insulating layer 20 is not necessary, the production steps can be simplified.

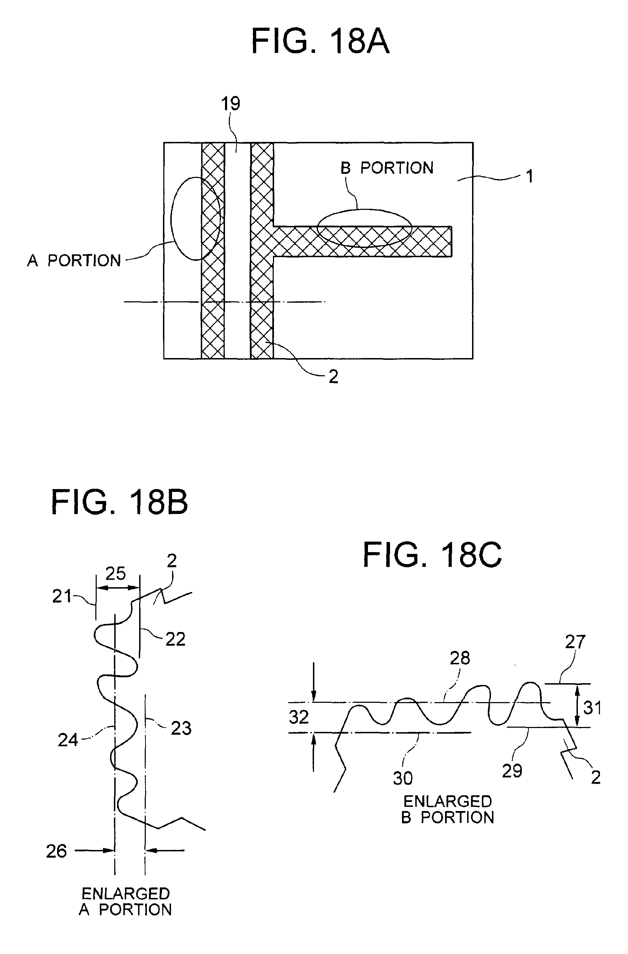

The masking layer 2 can be formed by various methods as described in Example 1. For example, when the masking layer 2 is formed by a screen printing method, there appears a tendency specific to the coating method. When a shape shown in Fig. 18A is printed, the left-hand end of the pattern indicated by A portion takes the shape as shown in Fig. 18B (enlarged view), wherein there arise concave and convex between the most left end 21 and the most right end 22 with the width 25 of 10 µm or more. This is caused by precision of printing screen, deformation of the printing screen caused by stress at the time of printing, and further sag of printing material. Generally speaking, when a photolithography is used, the concave and convex is about 1 µm. Further, the average position 24 of the left side shape shifts to the left with the length of numeral 26 compared with the position 23 on the design of the pattern of masking layer 2. This is caused by the shift of relative position with the printing screen and the semiconductor substrate 1 from the designed value. In a usual screen printing method, the shift is about 20 µm or more. The shift in the case of usual photolithography is about 1 µm.

As explained above using Figs. 17A and 17B, the difference in the width between the electrode 5 and the masking layer 2 should be larger than the total value of the concave and convex mentioned above and the shift of width. Further, by making the viscosity of the material for producing the masking layer 2 by screen printing method 50,000 to 1,000,000 cp, preferably 80,000 to 400,000 cp, it is possible to suppress blur and sag of the pattern. In addition, as to the B portion of the upper portion of pattern shown in Fig. 18A, there also arise the concave and convex of pattern (width 31) and positional shift 32 as shown in Fig. 18C like Fig. 18B. Numerals 27, 28, 29 and 30 denote the most upper portion, the average position in the longitudinal direction, the most lower position, the position on design in the longitudinal direction, respectively. Therefore, in the design of pattern, shifts of these values should be taken into consideration.

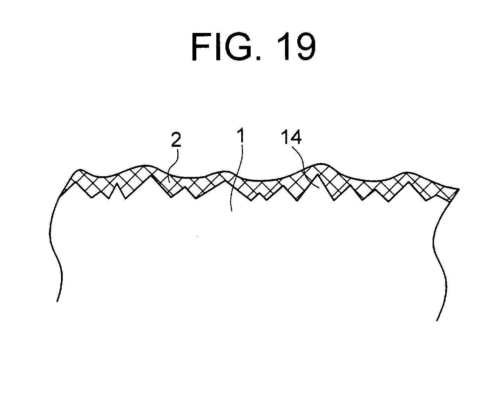

In Examples 1 to 12, although explanation is omitted, it is possible to make a large number of concaves and convexes 14 as shown in Fig. 19 with the maximum height of about 10 µm on the surface of photovoltaic cells in order to reduce reflection of light. In this case, by enhancing the viscosity of the material for masking layer 2 for example, the top of concaves and convexes 14 can be covered with the masking layer 2.

The electrode can be formed by a direct method for forming a pattern using a screen printing method, a photolithograhy method, or the like.

As the semiconductor substrate, there can be used those obtained by using single crystals of silicon, germanium, galllium arsenic, or multi crystals of these elements and having an outer shape of circle, square, etc. As the type of electroconductivity of the semiconductor substrate, there can be used any types of i-type, p-type, and n-type. Various combinations of dopant layers and type of electroconductivity of semiconductor substrates are possible so long as photovoltaic cells can be formed. As the dopant, there can be used phosphorus, arsenic, antimony, boron, aluminum, gallium and the like conventionally used dopants.

## Claims

1. A process for producing a photovoltaic cell, which comprises
a step of forming a dopant diffusion preventing mask on a surface of a semiconductor substrate by adhering a material for the dopant diffusion preventing mask in a pattern state to the semiconductor substrate surface, and
a step of forming a first dopant layer on a portion not covered by the dopant diffusion preventing mask by a first gas phase diffusion.

2. A process according to claim 1, which further comprises
a step of removing the dopant diffusion preventing mask after the first dopant layer forming step, and
a step of forming a second dopant layer by a second gas phase diffusion on the region from which the dopant diffusion preventing mask is removed.

3. A process according to claim 1, wherein the dopant diffusion preventing mask contains a dopant so as to function as a solid phase diffusion source, and a third dopant layer is formed under the dopant diffusion preventing mask.

4. A process according to claim 1, wherein the semiconductor substrate is made of silicon, the dopant diffusion preventing mask is made of an electrically insulating material and has an opening, said process further comprises after the step of forming the first dopant layer
a step of coating a metal containing a dopant which decides a type of electroconductivity in the opening in the dopant diffusion preventing mask,
a step of converting the first dopant layer to a dopant layer having an opposite electroconductivity by firing, and
a step of forming a metallic electrode for the impurity layer having the opposite electroconductivity.

5. A process according to claim 1, wherein the semiconductor substrate is made of silicon, the dopant diffusion preventing mask is made of an electrically insulating material and has an opening, said process further comprises after the step of forming the first dopant layer
a step of coating aluminum containing a dopant which decides a type of electroconductivity in the opening in the dopant diffusion preventing mask,
a step of converting the first dopant layer to a p-type dopant layer by firing, and
a step of forming an aluminum electrode for the p-type dopant layer.

6. A process according to claim 1, wherein a dopant layer having an opposite electroconductivity to the first dopant layer is formed before the step of formation of the dopant diffusion preventing mask.

7. A process according to claim 1, wherein the semiconductor substrate has a through-hole which penetrates from a front surface to a rear surface and said process comprising
a step of forming the first dopant layer on the front surface and rear surface of the semiconductor substrate having no dopant diffusion preventing mask and inside wall of the through-hole by the first gas phase diffusion.

8. A process for producing a photovaltaic cell, which comprises
a step of forming a dopant diffusion preventing mask on a surface of a semiconductor substrate by adhering a material for the dopant diffusion preventing mask in a pattern state to the semiconductor substrate surface,
a step of forming a solid phase diffusion source layer, and
a step of forming a first dopant layer on the portion having no dopant diffusion preventing mask by solid phase diffusion from the solid phase diffusion source layer.

9. A process according to claim 8, wherein the dopant diffusion preventing mask contains a dopant so as to function as a solid phase diffusion source, and a second dopant layer is formed under the dopant diffusion preventing mask.

10. A process according to claim 1 or 8, wherein the material for the dopant diffusion preventing mask is adhered to the semiconductor substrate by a printing method.

11. A process according to claim 1 or 8, wherein the material for the dopant diffusion preventing mask contains silicon oxide or silicon nitride.

12. A process according to claim 1, wherein the material for the dopant diffusion preventing mask has a viscosity of 500,000 cp to 1,000,000 cp.

13. A process according to claim 8, wherein the material for the dopant diffusion preventing mask and a material for the solid phase diffusion source layer have a viscosity of 500,000 cp to 1,000,000 cp.

14. A photovoltaic cell comprising a semiconductor substrate, an electrically insulating material layer formed on the semiconductor substrate by a coating method, and electrodes formed on openings of the electrically insulating material layer.

15. A photovoltaic cell according to claim 14, which further comprises a first dopant layer formed on outside of the electrically insulating material layer on the semiconductor substrate, and a second dopant layer having an opposite electroconductivity to the first dopant layer and formed in the opening of the electrically insulating material layer, said second dopant layer containing p-type dopant and n-type dopant.

16. A photovoltaic cell according to claim 15, wherein the fist dopant layer is an n-type dopant layer, the second dopant layer is a p-type dopant layer, the semiconductor substate is made of silicon, the electrode is made of aluminum, and said p-type dopant layer contains aluminum and an n-type dopant.

17. A photovoltaic cell comprising a semiconductor substrate, and a dopant layer formed on the semiconductor substrate and having different heights by 10 µm or more in periphery shape.

18. A photovoltaic cell according to claim 17, which further comprises a through-hole penetrating the semiconductor substrate from a front surface to a rear surface, and a dopant layer having the same electroconductivity and connecting the front surface, the rear surface and inside of through-hole.
